Europäisches Patentamt

European Patent Office

Office européen des brevets

(19)

(11) **EP 0 986 175 A1**

(12) **DEMANDE DE BREVET EUROPEEN**

(43) Date de publication:
**15.03.2000 Bulletin 2000/11**

(51) Int. Cl.7: **H03K 17/22**

(21) Numéro de dépôt: **98116952.7**

(22) Date de dépôt: **08.09.1998**

(84) Etats contractants désignés:
**AT BE CH CY DE DK ES FI FR GB GR IE IT LI LU MC NL PT SE**
Etats d'extension désignés:
**AL LT LV MK RO SI**

(71) Demandeur:
**EM Microelectronic-Marin SA**
**2074 Marin (CH)**

(72) Inventeur: **Jaeggi, Hugo**
**2046 Fontaines (CH)**

(74) Mandataire:
**Balsters, Robert et al**
**I C B,**
**Ingénieurs Conseils en Brevets S.A.,**
**7, rue des Sors**
**2074 Marin (CH)**

(54) **Circuit d'initialisation, notamment lors de la mise sous tension**

(57)     La présente invention concerne un circuit d'initialisation (10 ; 20 ; 30) pourvu d'une borne de sortie (18) connectée à un circuit intégré (2), ledit circuit d'initialisation pouvant fournir audit circuit intégré une tension électrique (RST0 ; RST1 ; RST2) pour initialiser ledit circuit intégré, notamment suite à l'application d'une tension d'alimentation (Vdd) au circuit d'initialisation et au circuit intégré. Ce circuit d'initialisation comprend un premier transistor à effet de champ (N0) commandé par la tension d'alimentation (Vdd), et connecté entre la masse et une première source de courant (16). Ce circuit d'initialisation a pour avantage de réaliser une surveillance de la tension d'alimentation fournie au circuit intégré, tout en occasionnant une consommation en courant continu d'environ 10 nA. Un autre agencement de ce circuit a pour avantage de permettre une utilisation de ce circuit avec des applications telles que les mémoires EEPROM.

Fig. 3

EP 0 986 175 A1

**Description**

La présente invention concerne le domaine des circuits d'initialisation, notamment lors de la mise sous tension et, plus précisément, un circuit d'initialisation pouvant être utilisé dans un circuit intégré fabriqué selon une filière de type CMOS.

Dans un circuit intégré, en particulier dans un circuit comprenant des composants fonctionnels tels que des bascules, des mémoires et des générateurs de signaux d'horloge, il est souvent nécessaire de réaliser une initialisation de ces composants suite à la connexion d'une source d'alimentation audit circuit intégré, de sorte que chacun des composants se trouve dans un état prédéterminé.

Les circuits d'initialisation qui réalisent une telle initialisation lors de la mise sous tension sont communément appelés circuits POR, acronyme provenant de l'anglais 〈〈 Power-On Reset 〉〉. Typiquement, un circuit POR fournit, suite à sa connexion à une source d'alimentation, une tension électrique ayant la forme d'une impulsion ayant des caractéristiques prédéterminées. Dans la suite de la description, on qualifiera également par l'acronyme 〈〈 POR 〉〉 la tension ainsi fournie par le circuit POR.

En outre, dans le cas où la source d'alimentation devient instable et ne fournit plus une tension d'alimentation comprise dans la plage de fonctionnement désirée, un nouveau signal d'initialisation est nécessaire pour rétablir le fonctionnement correct du circuit intégré, c'est-à-dire que la tension d'alimentation soit à nouveau égale à sa valeur nominale.

Une fois encore, une initialisation du circuit intégré est nécessaire, et doit être réalisée à l'instar d'un signal POR.

Il existe dans l'état de la technique de nombreux circuits d'initialisation, notamment des circuits POR.

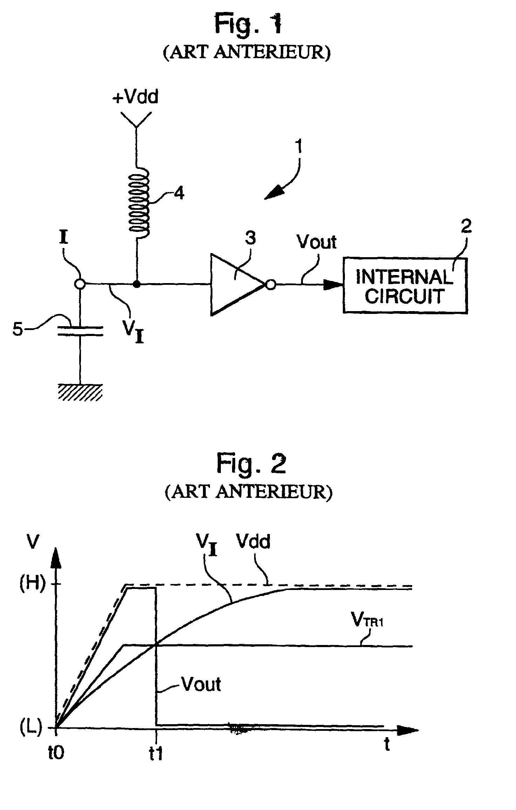

En référence à la figure 1 de la présente description, le brevet US 4.670.676 décrit un premier circuit d'initialisation classique 1 comprenant une borne de sortie connectée à un circuit intégré 2 pour l'initialiser, comme cela est décrit de façon détaillée ci-après. La figure 2 de la présente description représente quatre chronogrammes de tensions relatives au fonctionnement du circuit 1.

Comme le représente la figure 1, le circuit 1 comprend un inverseur 3 comprenant une borne d'entrée et une borne de sortie. La borne d'entrée de l'inverseur 3 est connectée, par l'intermédiaire d'un condensateur 5, à la masse et, par l'intermédiaire d'une résistance 4, à une source d'alimentation (non représentée en figure 1) pouvant fournir une tension d'alimentation Vdd. On note que la résistance 4 et le condensateur 5 forment ensemble un circuit RC, et fournissent un signal d'entrée $V_I$ à l'inverseur 3. Ce dernier pouvant inverser la polarité du signal d'entrée $V_I$, et fournir le résultat de cette inversion sous la forme d'une tension de sortie Vout fournie par ladite borne de sortie du circuit d'initialisation 1.

On va maintenant décrire le fonctionnement du circuit 1, en relation avec les figures 1 et 2 déjà citées.

A un instant t0, la source d'alimentation est connectée aux circuits 1 et 2 pour fournir la tension d'alimentation Vdd qui va croître linéairement avec le temps t d'un seuil de tension 〈〈 L 〉〉, à l'instant t0, jusqu'à un seuil de tension 〈〈 H 〉〉. Suite à cette connexion, la tension $V_I$ augmente avec une constante de temps déterminée par la résistance 4 et le condensateur 5, et la tension de transition $V_{TR1}$ de l'inverseur 3 augmente proportionnellement avec la tension d'alimentation Vdd. Sachant que la tension de sortie Vout est égale au seuil de tension 〈〈 H 〉〉 quand la tension d'entrée $V_I$ de l'inverseur 3 est intérieure à la tension de transition $V_{TR1}$, la tension de sortie Vout croit linéairement jusqu'à atteindre le niveau de tension 〈〈 H 〉〉 durant l'intervalle de temps délimité par les instants t0 et t1. Dès lors que la tension d'entrée $V_I$ est supérieure à la tension de transition $V_{TR1}$ (c'est-à-dire dès l'instant t1), l'inverseur 3 fournit le niveau de tension 〈〈 L 〉〉. En d'autres termes, a partir de l'instant t1, la tension de sortie Vout chute pour atteindre le niveau de tension 〈〈 L 〉〉. Ainsi, la tension Vout a la forme d'une impulsion au cours de la période comprise entre les instants t0 et t1, de manière à commander l'initialisation du circuit interne 3 au cours de cette période.

Un inconvénient du circuit d'initialisation décrit en relation avec les figures 1 et 2, réside dans le fait que la tension de transition $V_{TR1}$ de l'inverseur 3 est proportionnelle à la tension d'alimentation Vdd. Il en résulte que la tension d'initialisation Vout a la forme d'une impulsion dont la largeur est liée à la tension d'alimentation Vdd, et que cette largeur varie donc en fonction des fluctuations de la tension d'alimentation Vdd.

Un autre inconvénient du circuit d'initialisation décrit en relation avec les figures 1 et 2, réside dans le fait que le temps de montée de la tension d'alimentation Vdd peut être supérieur à la constante de temps du circuit RC. Il en résulte que la tension d'initialisation Vout est toujours au niveau de tension 〈〈 L 〉〉, c'est-à-dire qu'aucune impulsion n'est fournie au circuit interne 3, et que ce dernier n'est donc pas initialisé, malgré sa connexion à ladite source d'alimentation.

Un autre inconvénient du circuit d'initialisation décrit en relation avec les figures 1 et 2, réside dans le fait qu'il fournit un signal POR uniquement suite à la mise sous tension, et ne peut fournir ultérieurement un nouveau signal d'initialisation, d'où il résulte que ce circuit ne permet pas à lui-seul de réaliser une surveillance de la tension d'alimentation au-delà de la mise sous tension.

Le brevet US 4.300.065 décrit un deuxième circuit d'initialisation classique qui présente l'inconvénient de fonctionner pour de faibles tensions d'alimentation, ce qui ne permet de l'utiliser sur une plage de tension d'alimentation plus large. Autrement dit, l'utilisation de ce circuit est limitée à certaines applications, et ne peut être étendue à des applications qui nécessitent des niveaux de tension d'alimentation plus élevés, telles que des mémoires EEPROM et des convertisseurs analogiques-numériques. Le circuit décrit dans le brevet US 4.300.065 déjà cité présente l'inconvénient supplémentaire d'avoir une consommation en courant relativement grande.

Le brevet US 5.744.990 décrit un circuit POR présentant l'inconvénient de comprendre un grand nombre de transistors, ce qui va à l'encontre des préoccupations habituelles dans l'industrie des semi-conducteurs de rationalité et d'occupation de surface de substrat.

Un objet de la présente invention est de prévoir un circuit d'initialisation, notamment lors de la mise sous tension, ce circuit palliant les inconvénients susmentionnés.

Plus précisément, un objet de la présente invention est de prévoir un circuit d'initialisation pouvant garantir l'initialisation du circuit intégré, suite à la mise sous tension et à une fourniture instable de la tension d'alimentation.

Un autre objet de la présente invention est de fournir un circuit de ce type pouvant réaliser une initialisation du circuit intégré, même si le temps de montée de la tension d'alimentation est très faible.

Un autre objet de la présente invention est de prévoir un circuit de type susmentionné pouvant surveiller la tension d'alimentation et fournir une impulsion d'initialisation au circuit intégré, quand la tension d'alimentation n'est plus comprise dans une plage de fonctionnement désirée.

Un autre objet de la présente invention est de prévoir un circuit d'initialisation compatible avec des circuits intégrés pouvant s'initialiser à des seuils de tension compris entre 1.6 et 1.8 V, pour permettre d'utiliser ce circuit d'initialisation avec des applications telles que des mémoires EEPROM et des convertisseurs analogiques-numériques, qui nécessitent des niveaux minimaux de tension d'alimentation de l'ordre de 1.6 V.

Un autre objet de la présente invention est de prévoir un circuit d'initialisation pouvant fournir une tension d'initialisation adaptée aux composants du circuit intégré à initialiser, c'est-à-dire tenir compte des fluctuations des paramètres de ces composants issues du procédé de fabrication.

Un autre objet de la présente invention est de prévoir un circuit d'initialisation consommant un courant continu de l'ordre de quelques dizaines de nanoampères dans la plage de fonctionnement du circuit intégré.

Ces objets, ainsi que d'autres, sont atteints par le circuit d'initialisation selon la revendication 1.

Le circuit d'initialisation selon la présente invention comprend un premier transistor connecté à une source de courant de sorte que la tension d'alimentation est comparée à un seuil d'initialisation prédéterminé, la fourniture de la tension d'initialisation étant fonction du résultat de cette comparaison. Cet agencement a pour avantage de fournir une impulsion d'initialisation, suite à l'application de la tension d'alimentation.

Un autre avantage de l'agencement du circuit d'initialisation selon la présente invention est que le seuil d'initialisation ne dépend pas de la tension d'alimentation, ni des fluctuations de cette dernière, ce qui garantit la fourniture d'une impulsion d'initialisation.

Un autre avantage de l'agencement de type susmentionné est de fournir une impulsion d'initialisation, indépendamment du temps de montée de la tension d'alimentation.

Un autre avantage de l'agencement de type susmentionné est de pouvoir fournir une impulsion d'initialisation, suite à une fourniture instable de la tension d'initialisation, ce qui réalise une fonction de surveillance de cette tension.

Un autre avantage de l'agencement de type susmentionné est que le seuil d'initialisation dépend de paramètres liés au procédé de fabrication, tels que la longueur nominale de canal du premier transistor, ce qui permet de fixer ce seuil à une valeur prédéterminée.

Un autre avantage de l'agencement de type susmentionné est de fonctionner en occasionnant une consommation en courant continu d'environ 10 nA.

Le circuit d'initialisation selon la présente invention peut comprendre un deuxième transistor connecté à une deuxième source de courant fournissant un courant ayant une intensité de 10 nA. Cet agencement a pour avantage de conférer au circuit d'initialisation un seuil d'initialisation plus élevé, ce qui permet d'utiliser ce circuit pour des applications particulières telles que les mémoires EEPROM.

Le circuit d'initialisation selon la présente invention peut comprendre une pluralité de deuxièmes transistors connecté à une deuxième source de courant fournissant un deuxième courant ayant une intensité de 10 nA. Cet agencement a pour avantage de conférer au circuit d'initialisation un seuil d'initialisation d'autant plus élevé que le nombre de deuxièmes transistors est élevé.

Un autre avantage de cet agencement est de nécessiter une consommation en courant continu de l'ordre de 20 nA, quel que soit le nombre de deuxièmes transistors.

Le circuit selon la présente invention peut être réalisé de façon monolithique avec le circuit intégré, ce qui a pour avantage de réaliser une adaptation du circuit d'initialisation au circuit intégré.

Le circuit d'initialisation selon la présente invention comprend un nombre limité de composants qui a pour avantage de conférer au circuit une structure peu complexe et peu encombrante, et donc peu coûteuse.

Ces objets, caractéristiques et avantages, ainsi que d'autres, de la présente invention apparaîtront plus clairement à la lecture de la description détaillée d'un mode de réalisation préféré de l'invention, donné à titre d'exemple uniquement, en relation avec les figures jointes, parmi lesquelles :

- la figure 1 déjà citée représente un circuit d'initialisation classique;
- la figure 2 déjà citée représente quatre chronogrammes de tensions relatives au fonctionnement du circuit d'initialisation de la figure 1;
- la figure 3 représente un mode de réalisation préféré d'un circuit d'initialisation selon la présente invention;
- la figure 4 représente un premier perfectionnement du circuit d'initialisation de la figure 3;
- la figure 5 représente un deuxième perfectionnement du circuit d'initialisation de la figure 3; et
- la figure 6 représente quatre chronogrammes de tension relatives aux fonctionnements des circuits d'initialisation des figures 3 à 5.

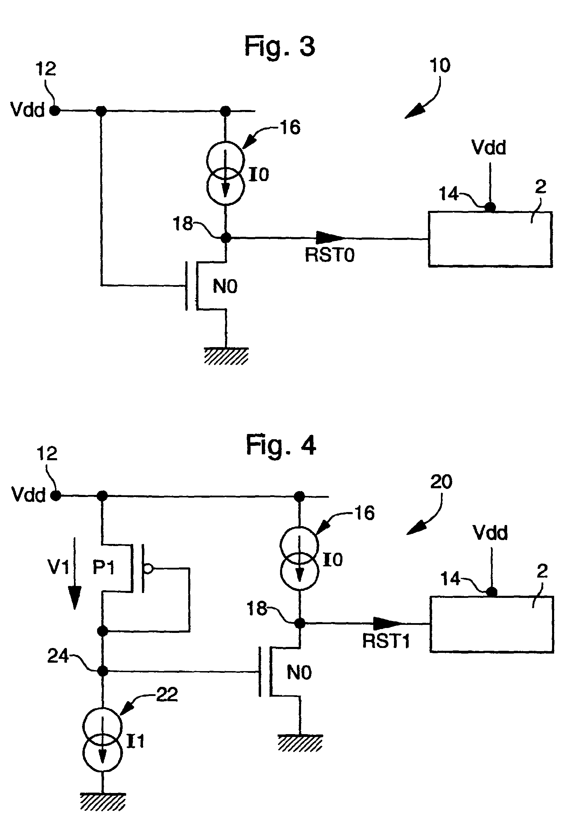

La figure 3 représente un mode de réalisation préféré d'un circuit d'initialisation, notamment lors de la mise sous tension selon la présente invention, ce circuit étant désigné par la référence 10.

Le circuit d'initialisation 10 comprend une borne d'alimentation 12 connectée à une source d'alimentation (non représentée), de sorte que cette source peut fournir une tension d'alimentation Vdd au circuit d'initialisation 10, par la borne 12. Le circuit d'initialisation 10 comprend en outre une borne de sortie 18 connectée à un circuit intégré 2 destiné à être initialisé par le circuit d'initialisation 10. Le circuit intégré 2 comprend une borne d'alimentation 14, de sorte que ladite source d'alimentation peut fournir également la tension d'alimentation Vdd au circuit intégré 2, par la borne 14.

Le circuit d'initialisation 10 est agencé de sorte que, suite à l'application de la tension d'alimentation Vdd aux bornes 12 et 14, il peut fournir, par la borne 18, une tension électrique RST0 au circuit intégré 2, cette tension étant propre à commander une initialisation du circuit intégré 2.

A cet effet, le circuit d'initialisation 10 comprend un transistor à effet de champ N0 commandé par la tension d'alimentation Vdd. Le transistor N0 est connecté entre la masse et la borne de sortie 18.

On note en figure 3 que le canal du transistor N0 est de type N, ce type de conductivité étant donné à titre illustratif uniquement. De préférence, on réalise le transistor N0 par un procédé de fabrication de type CMOS connu en soi, le dimensionnement de ce transistor étant décrit de façon plus détaillée ci-après.

En outre, une source de courant 16 est connecté à la borne 18, et est agencé pour pouvoir fournir un courant I1 de sorte que deux courants arrivent sur la borne 18, d'une part le courant traversant le transistor N0 et d'autre part le courant I1.

On note en figure 3 que le circuit d'initialisation 10 comprend la source de courant 16. De préférence, on réalise la source de courant 16 en utilisant un moyen de fourniture agencé pour fournir un courant stable, dès que la tension d'alimentation Vdd a atteint un seuil de tension minimal Vmin, c'est-à-dire un courant dont l'intensité est sensiblement constante quand la tension d'alimentation est supérieure au seuil Vmin. L'homme de l'art notera que le seuil Vmin correspond à une valeur de tension d'alimentation qui est suffisante pour permettre la réalisation des fonctions logiques du circuit intégré 2. Un tel moyen de fourniture est connu dans la technique, notamment par l'article ⟨⟨ CMOS Analog Integrated Circuits Based on Weak Inversion Operation ⟩⟩ de E. Vittoz et al., IEEE Journal of Solid States Circuits, vol. SC-12, N° 3, Juin 1977. En outre, ce moyen de fourniture est agencé pour fournir le courant I1 au circuit d'initialisation 10, de sorte que l'intensité de ce courant est de l'ordre de 10 nA.

A titre de variante de réalisation de la source de courant 16, la source de courant 16 peut être incluse dans le circuit intégré 2. Autrement dit, dans cette variante de réalisation, un composant du circuit intégré 2 est agencé pour fournir le courant I1 au circuit d'initialisation 10, de sorte que l'intensité de ce courant est de l'ordre de 10 nA.

L'homme de l'art note que l'intensité du courant I1 est déterminée par la valeur de la tension d'alimentation Vdd fournie sur la borne de commande du transistor N0. Il se produit ainsi une comparaison entre le courant traversant le transistor N0 et le courant I1 dont la valeur dépend directement de la tension d'alimentation Vdd, et fournit la tension d'initialisation RST0 en fonction du résultat de cette comparaison, comme cela est décrit de façon plus détaillée ci-après. En d'autres termes, le transistor N0 et la source de courant 16 réalisent ensemble une comparaison de la tension d'alimentation à un seuil de tension appelé, dans la suite de la description, ⟨⟨ seuil d'initialisation ⟩⟩. Le seuil d'initialisation associé au circuit d'initialisation 10 est désigné par la référence $V_{RST0}$, et est défini selon la formule suivante :

$$V_{RST0} = Vth_{N0} + (2I_{DS(N0)}/\beta_{N0})^{1/2} \qquad (1)$$

où la référence $Vth_{N0}$ désigne la tension de seuil du transistor N0, la référence $I_{DS(N0)}$ désigne l'intensité du courant traversant le transistor N0, et la référence $\beta_{N0}$ désigne le gain du transistor N0, ce gain étant défini par la formule suivante :

$$\beta_{N0} = k_{N0}*W_{N0}/L_{N0} \qquad (2)$$

où la référence $k_{N0}$ désigne la transductance du transistor N0, et les références $W_{N0}$ et $L_{N0}$ désignent respectivement les largeur et longueur nominales du canal du transistor N0.

L'homme de l'art note que le circuit d'initialisation 10 peut être réalisé selon un procédé de fabrication de circuit intégré de type CMOS, les étapes de ce procédé étant connues en soi. En particulier, le circuit d'initialisation 10 et le circuit intégré 2 peuvent être réalisés de façon monolithique dans un substrat semi-conducteur, selon un procédé de type susmentionné. Un tel procédé est considéré comme évident pour l'homme de l'art, eu égard à ses connaissances dans de domaine de la fabrication des semi-conducteurs. Ainsi, ce procédé dont le produit obtenu est la structure décrite en relation avec la figure 3, ne sera pas décrite de façon détaillée dans la présente description.

L'homme de l'art note également que le circuit d'initialisation 10 nécessite une consommation en courant continu d'environ 10 nA, ce qui est particulièrement avantageux par rapport aux circuits d'initialisation classiques susmentionnés. En effet, cette valeur est suffisamment petite pour minimiser la consommation en courant du circuit d'initialisation 10, et suffisamment grande pour être supérieure à l'intensité des signaux parasites, ainsi qu'à celle des courants de fuite.

On va maintenant décrire deux perfectionnements du circuit d'initialisation de la figure 3.

La figure 4 représente un premier perfectionnement du circuit d'initialisation de la figure 3, ce perfectionnement étant désigné par la référence 20. Ainsi, les composants représentés en figures 4, et désignés par les mêmes références que ceux représentés en figure 3 sont sensiblement identiques à ceux représentés en figure 3. On note que le circuit d'initialisation 20 fournit une tension d'initialisation RST1.

Comme le représente la figure 4, le circuit d'initialisation 20 comprend en outre un transistor à effet de champ P1 monté en diode entre la borne d'alimentation 12 et la borne de commande du transistor N0.

On note en figure 4 que le canal du transistor P1 est de type P, c'est-à-dire d'un type de conductivité différent de celui du canal du transistor N0. A l'instar du transistor N0, on réalise de préférence le transistor P1 par un procédé de fabrication de type CMOS connu en soi, le dimensionnement de ce transistor étant décrit de façon plus détaillée ci-après.

Le noeud de connexion 24 entre le transistor P1 et la borne de commande du transistor N0 est connecté à une deuxième source de courant 22 pouvant fournir un courant I2, de sorte deux courants arrivent sur le noeud 24, d'une part, le courant traversant le transistor P1 et, d'autre part, le courant I2. Et il se produit à la borne 18 une comparaison entre le courant traversant le transistor P1 et le courant I2, comme cela est décrit de façon plus détaillée ci-après.

On note en figure 4 que le circuit d'initialisation 20 comprend la source de courant 22. Cette dernière peut être réalisée à l'instar de la source de courant 16, c'est-à-dire à partir d'un moyen de fourniture de courant stable tel que décrit dans l'article déjà cité de E. Vittoz et al., ce moyen pouvant fournir le courant I1 au circuit d'initialisation 20, de sorte que l'intensité de ce courant est de l'ordre de 10 nA.

A titre de variante de réalisation, la source de courant 22 peut être incluse dans le circuit intégré 2. Autrement dit, dans cette variante de réalisation, un composant du circuit intégré 2 est agencé pour fournir le courant I1 au circuit d'initialisation 20, de sorte que l'intensité de ce courant est de l'ordre de 10 nA.

A l'instar du circuit d'initialisation 10, les transistors N0 et P1 réalisent avec les sources de courant 16 et 22 une comparaison de la tension d'alimentation Vdd à un seuil d'initialisation. Le seuil d'initialisation associé au circuit d'initialisation 20 est désigné par la référence $V_{RST1}$, et est défini selon la formule suivante :

$$V_{RST1} = V_{RST0} + Vth_{P1} + (2I_{DS(P1)}/\beta_{P1})^{1/2} \tag{3}$$

où la référence $Vth_{P1}$ désigne la tension de seuil du transistor P1, la référence $I_{DS(P1)}$ désigne l'intensité du courant traversant le transistor P1, et la référence $\beta_{P1}$ désigne le gain du transistor P1, ce gain étant défini par la formule suivante :

$$\beta_{P1} = k_p * W_{P1}/L_{P1} \tag{4}$$

où la référence $k_{P1}$ désigne la transductance du transistor P1, et les références $W_{P1}$ et $L_{P1}$ désignent respectivement les largeur et longueur nominales du canal du transistor P1.

En sus de ce qui a déjà été mentionné ci-dessus en relation avec le seuil $V_{RST0}$, on note que le seuil $V_{RST1}$ est supérieur au seuil $V_{RST0}$. Ceci est particuliérement avantageux par rapport aux circuits d'initialisation classiques susmentionnés, puisque le seuil d'initialisation $V_{RST1}$ est plus grande ce qui permet d'utiliser ce circuit pour des applications particulières telles que les mémoires EEPROM qui nécessitent des niveaux minimaux de tension d'alimentation de cet ordre. A titre illustratif uniquement, le seuil $V_{RST1}$ peut être égal d'environ 1.7 V,

L'homme de l'art note que le circuit d'initialisation 10 peut être réalisé selon un procédé de fabrication de circuit intégré de type CMOS, les étapes de ce procédé étant connues en soi. En particulier, le circuit d'initialisation 20 et le circuit intégré 2 peuvent être réalisés de façon monolithique dans un substrat semi-conducteur, selon un procédé de type susmentionné. Un tel procédé est considéré comme évident pour l'homme de l'art, eu égard à ses connaissances dans de domaine de la fabrication des semi-conducteurs. Ainsi, ce procédé dont le produit obtenu est la structure décrite en relation avec la figure 4, ne sera pas décrite de façon détaillée dans la présente description.

L'homme de l'art note également que le circuit d'initialisation 20 nécessite une consommation en courant continu d'environ 20 nA, ce qui est particulièrement avantageux par rapport aux circuits d'initialisation classiques susmentionnés. En effet, cette valeur est suffisamment petite pour minimiser la consommation en courant du circuit d'initialisation 20, et suffisamment grande pour être supérieure à l'intensité des signaux parasites, ainsi qu'à celle des courants de fuite.

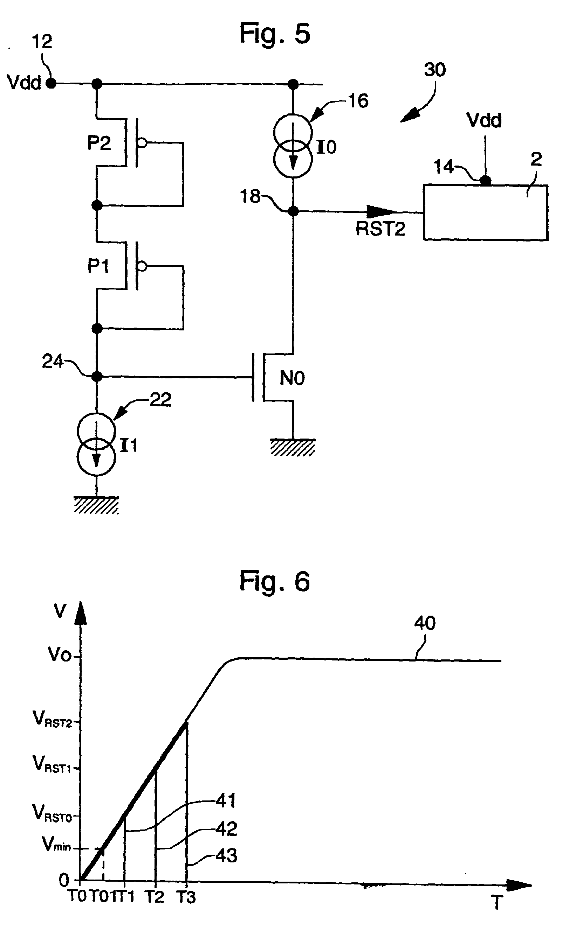

La figure 5 représente un deuxième perfectionnement du circuit d'initialisation de la figure 3, ce perfectionnement étant désigné par la référence 30. Ainsi, les composants représentés en figures 5, et désignés par les mêmes références que ceux représentés en figures 3 et 4 sont sensiblement identiques à ceux représentés en figures 3 et 4. On note que le circuit d'initialisation 30 fournit une tension d'initialisation RST2.

Comme le représente la figure 5, le circuit d'initialisation 30 comprend en outre un transistor à effet de champ P2 à canal dudit deuxième type de conductivité, ce transistor étant monté en diode et connecté en série entre le transistor P1 et la borne d'alimentation 12.

A l'instar du circuit d'initialisation 20, les transistors N0, P1 et P2 réalisent avec les sources de courant 16 et 22 une comparaison de la tension d'alimentation Vdd à un seuil d'initialisation. Le seuil d'initialisation associé au circuit d'initialisation 30 est désigné par la référence $V_{RST1}$, et est défini selon la formule suivante :

$$V_{RST2} = V_{RST1} + Vth_{P2} + (2I_{DS(P2)}/\beta_{P2})^{1/2} \tag{5}$$

où la référence $Vth_{P2}$ désigne la tension de seuil du transistor P2, la référence $I_{DS(P2)}$ désigne l'intensité du courant traversant le transistor P2, et la référence $\beta_{P2}$ désigne le gain du transistor P2, ce gain étant défini par la formule suivante :

$$\beta_{P2} = k_{p2} * W_{P2}/L_{P2} \tag{6}$$

où la référence $k_{p2}$ désigne la transductance du transistor P2, et les références $W_{P2}$ et $L_{P2}$ désignent respectivement les largeur et longueur nominales du canal du transistor P2.

A titre de variante de réalisation du circuit d'initialisation 30, le circuit d'initialisation selon la présente invention peut comprendre M transistors identiques au transistor P2 du circuit 30. Dans ce cas, les M transistors P2 sont montés en diode et connectés en série entre le transistor P1 et la borne d'alimentation 12. On associe à un tel circuit un nouveau seuil d'initialisation désigné par la référence $V_{RSTM}$. La Demanderesse a déterminé que :

$$V_{RSTM} = V_{RST1} + M * [Vth_{P2} + (2I_{DS(P2)}/\beta_{P2})^{1/2}]$$

En sus de ce qui a déjà été mentionné ci-dessus en relation avec le seuil $V_{RST1}$, on note que le seuil $V_{RST2}$ est supérieur au seuil $V_{RST1}$, et que le seuil $V_{RSTM}$ est sensiblement supérieur au seuil $V_{RST1}$. On note également que le circuit d'initialisation 30 nécessite une consommation en courant continu d'environ 20 nA, quel que soit le nombre de transistors P2, ce qui est particulièrement avantageux par rapport aux circuits d'initialisation classiques susmentionnés.

On va maintenant décrire les fonctionnements des circuits d'initialisation des figures 3 à 5, en se référant à la figure 6 qui représente quatre chronogrammes de tension relatives à ces circuits.

La référence 40 désigne un chronogramme de la tension d'alimentation Vdd, et les références 41, 42 et 43 désignent des chronogrammes des tensions d'initialisation respectives RST0, RST1 et RST2 associées aux circuits respectifs 10, 20 et 30.

Considérons le circuit d'initialisation 10 de la figure 3.

A un instant T0, la tension d'alimentation Vdd est appliquée sur la borne 12. Cette tension croît linéairement jusqu'à sa valeur nominale Vo, comme l'illustre la courbe 40. A l'instant T0, la tension de commande du transistor N0 (c'est-à-dire la tension Vdd) est nulle, donc inférieure à la tension de seuil $Vth_{N0}$ de ce transistor. Il en résulte que le transistor N0 est bloqué, et que la tension d'initialisation RST0 est sensiblement égale à la tension d'alimentation Vdd. Puis la tension d'initialisation RST0 suit la croissance de la tension d'alimentation Vdd, comme l'illustre la courbe 41.

A un instant T01, la tension d'alimentation Vdd a atteint le seuil de tension Vmin qui correspond à une valeur de tension d'alimentation suffisante pour permettre la réalisation des fonctions logiques du circuit intégré 2. On rappelle que, au-delà du seuil de tension Vmin, les courants I1 et I2 sont stables.

A un instant T1, la tension Vdd atteint le seuil $V_{RST0}$, c'est-à-dire que la tension de commande du transistor N0 est suffisante pour que ce transistor devienne passant. Il en résulte que le transistor N0 tire le potentiel électrique de la borne 18 vers la masse, c'est-à-dire que la tension d'initialisation RST0 chute brutalement et devient nulle. Au-delà de l'instant T1, la tension dalimentation Vdd est supérieure au seuil $V_{RST0}$, et par conséquent le transistor demeure passant. On note que la tension d'initialisation RST0 a la forme d'une impulsion dont la valeur maximale est égale à la valeur $V_{RST0}$, comme cela a déjà été mentionné ci-dessus.

L'homme de l'art notera que la fourniture d'une telle impulsion est liée au fait que la tension d'alimentation Vdd est inférieure au seuil d'initialisation $V_{RST0}$. Ainsi, supposons que, à un instant ultérieur à l'instant T1, la tension d'alimentation Vdd chute au-dessous du seuil d'initialisation $V_{RST0}$. Il en résulte que le transistor N0 est à nouveau bloqué, et la situation devient similaire à celle lors de la mise sous tension, c'est-à-dire que le circuit d'initialisation 10 fournit une nouvelle impulsion similaire à celle fournie entre les instants T0 et T1. Autrement dit, le circuit d'initialisation 10 réalise également la fonction de surveillance de la tension d'alimentation, c'est-à-dire peut commander une initialisation du circuit intégré 2, dans le cas où la source d'alimentation devient instable et ne fournit plus la tension d'alimentation Vdd dans la plage de fonctionnement désirée.

D'après les formules (1) et (2), on note que le seuil $V_{RST0}$ n'est pas lié à la tension d'alimentation Vdd. Ceci est avantageux par rapport aux circuits d'initialisation classiques susmentionnés, puisque la tension d'alimentation Vdd est comparée à un seuil qui ne dépend lui-même pas de la tension d'alimentation, ni des fluctuations de cette dernière, ce qui garantit la fourniture de l'impulsion d'initialisation.

D'après les formules (1) et (2), on note également que le seuil $V_{RST0}$ dépend de paramètres liés au procédé de fabrication du transistor N0, tels que la tension de seuil et les largeur et longueur nominales du canal. Ceci est particulièrement avantageux par rapport aux circuits d'initialisation classiques susmentionnés, puisque on peut réaliser le transistor N0 de manière à fixer le seuil d'initialisation à une valeur prédéterminée. A titre d'exemple, supposons que l'on souhaite obtenir une valeur élevée du seuil $V_{RST0}$, on réalise le transistor N0 de sorte que la longueur nominale de canal de ce transistor est élevée, ou que l'intensité du courant $I_{DS(N0)}$ traversant ce transistor est élevée.

Un autre avantage d'une telle dépendance entre le seuil d'initialisation $V_{RST0}$ et les paramètres du transistor N0 est de réaliser une adaptation de ce seuil avec les composants du circuit intégré 2 tels que fabriqués. Par exemple, supposons que le circuit intégré 2 comprend des transistors ayant des tensions de seuil faible, ces transistors réalisant les fonctions logiques de ce circuit. Il en résulte que ce circuit peut fonctionner à des niveaux de tension d'alimentation plus bas. Par ailleurs, le fonctionnement de ce circuit intégré doit être compatible avec la fourniture de signaux d'initialisation. Dans ce cas, le circuit d'initialisation 10 réalisé de façon monolithique avec le circuit intégré décrit ci-dessus, comprend le transistor N0 dont la tension de seuil est également plus faible, ce qui permet d'obtenir un seuil d'initialisation plus petit, c'est-à-dire initialiser le circuit intégré à un niveau de tension d'alimentation plus petit, de sorte que ce dernier peut fonctionner à des niveaux de tension d'alimentation plus bas.

Considérons maintenant le circuit d'initialisation 20 de la figure 4.

A l'instant T0, la tension d'alimentation Vdd est appliquée sur la borne 12. Cette tension croît linéairement jusqu'à sa valeur nominale Vo, comme l'illustre la courbe 40. Dans la suite de la description, on désigne par la référence $V_A$ la tension électrique présente entre le noeud de connexion 24 et la masse. On note que la tension $V_A$ est égale à la tension de commande du transistor P1, et est déterminée par la formule suivante :

$$V_A = Vdd-V1 \tag{7}$$

où la référence V1 désigne la tension électrique présente entre la borne de drain et la borne de source du transistor P1. A l'instant T0, le transistor P1 est bloqué, et par conséquent le noeud de connexion 24 est tiré vers la masse. Autrement dit, la tension $V_A$ est nulle. Puisque la tension $V_A$ est égale à la tension de commande du transistor P1, le transistor N0 est également bloqué, et la tension d'initialisation RST1 est sensiblement égale à la tension d'alimentation Vdd. Puis la tension d'initialisation RST1 suit la croissance de la tension d'alimentation Vdd, comme l'illustre la courbe 42.

A un instant ultérieur à l'instant T0, la tension Vdd va dépasser la tension de seuil $Vth_{P1}$, le transistor P1 devient alors conducteur et la tension $V_A$ commencer à croître. A un instant T2, la tension d'alimentation Vdd atteint le seuil $V_{RST1}$. On rappelle d'après la formule (3) que :

$$V_{RST1} = V_{RST0}+Vth_{P1}+(2I_{DS(P1)}/\beta_{P1})^{1/2}$$

Autrement dit, à l'instant T2, la tension $V_A$ dépasse la tension de seuil $Vth_{N0}$ du transistor N0, d'où il résulte que ce transistor devient passant. Ainsi, à l'instant T2, la tension d'initialisation RST1 chute à zéro, comme l'illustre la courbe 42, et la situation devient identique à celle décrite à l'instant T1 en relation avec la courbe 41.

Considérons finalement le circuit d'initialisation 30 de la figure 5. A un instant t0, la tension d'alimentation Vdd est appliquée sur la borne 12. Cette tension croît linéairement jusqu'à sa valeur nominale Vo. A l'instant T0, la tension Vdd est nulle. A un instant ultérieur, la tension Vdd va dépasser la valeur $Vth_{P1}+Vth_{P2}$, les transistors P1 et P2 deviennent alors conducteurs et la tension $V_A$ commencer à croître. A un instant t3, la tension d'alimentation Vdd atteint le seuil $V_{RST2}$. On rappelle d'après la formule (5) que :

$$V_{RST1} = V_{RST1}+Vth_{P1}+(2I_{DS(P1)}/\beta_{P1})^{1/2}$$

Autrement dit, à l'instant T3, la tension $V_A$ dépasse la tension de seuil $Vth_{N0}$ du transistor N0, d'où il résulte que ce transistor devient passant. Ainsi, à l'instant T3, la tension d'initialisation RST2 chute à zéro, comme l'illustre la courbe 43, et la situation devient alors identique à celle décrite à l'instant T1 en relation avec la courbe 41.

Il va de soi pour l'homme de l'art que la description détaillée ci-dessus peut subir diverses modifications sans sortir du cadre de la présente invention. A titre de variante, on peut réaliser un circuit d'initialisation selon la présente invention, en formant des transistors à effet de champ dont les canaux ont des types de conductivité inverses à ceux décrits en relation avec les figures 3 à 5.

A titre de perfectionnement, le circuit d'initialisation selon la présente invention peut comprendre en outre un inverseur connecté entre ladite borne de sortie du circuit d'initialisation et ledit circuit intégré, de sorte que cet inverseur fournit ladite tension d'initialisation. Dans ce cas, cet inverseur comprendre des transistors ayant de faibles courants transversaux. On note que cet agencement d'un tel inverseur permet de limiter la consommation de courant à l'instant T1, en se référant à nouveau à la figure 6.

A titre de perfectionnement également, le circuit d'initialisation selon la présente invention peut comprendre un amplificateur connecté entre ladite borne de sortie du circuit d'initialisation et ledit circuit intégré, de sorte que cet amplificateur fournit ladite tension d'initialisation. On note que la tension d'initialisation fournie par ledit amplificateur a la forme d'une impulsion ayant un front plus vertical que les fronts des impulsions fournies par les circuits décrits en relation avec les figures 3 à 5.

## Revendications

1. Circuit d'initialisation (10 ; 20 ; 30) pourvu d'une première borne d'alimentation (12) et d'une borne de sortie (18) connectée à un circuit intégré (2) comprenant une deuxième borne d'alimentation (14), ledit circuit d'initialisation pouvant, suite à la mise sous tension et à une fourniture instable d'une tension d'alimentation (Vdd), fournir audit circuit intégré une impulsion sous la forme d'une tension électrique (RST0 ; RST1 ; RST2) pour initialiser ledit circuit intégré, ledit circuit d'initialisation étant caractérisé en ce qu'il comprend un premier transistor à effet de champ (N0) commandé par la tension d'alimentation (Vdd), et connecté entre la masse et une première source de courant (16), le noeud de connexion entre ledit premier transistor et ladite première source de courant (16) étant connectés à ladite borne de sortie, de sorte que ladite tension d'alimentation est comparée à un seuil d'initialisation ($V_{RST0}$ ; $V_{RST1}$ ; $V_{RST2}$) prédéterminé, la forme de ladite tension d'initialisation fournie étant fonction du résultat de cette comparaison.

2. Circuit d'initialisation (10) selon la revendication 1, caractérisé en que ledit seuil d'initialisation ($V_{RST0}$) est défini selon la formule suivante :

$$V_{RST0} = Vth_{N0} + (2I_{DS(N0)}/\beta_{N0})^{1/2}$$

où la référence $Vth_{N0}$ désigne la tension de seuil dudit premier transistor (N0), la référence $I_{DS(N0)}$ désigne l'intensité du courant traversant ledit premier transistor, et la référence $\beta_{N0}$ désigne le gain du transistor N0, ce gain étant défini par la formule suivante :

$$\beta_{N0} = k_{N0} * W_{N0}/L_{N0}$$

où la référence $k_{N0}$ désigne la transductance dudit premier transistor, et les références $W_{N0}$ et $L_{N0}$ désignent respectivement les largeur et longueur nominales du canal dudit premier transistor.

3. Circuit d'initialisation (10 ; 20 ;30) selon la revendication 1, caractérisé en que le canal dudit premier transistor (N0) est d'un premier type de conductivité, et en ce que ledit circuit d'initialisation comprend en outre un deuxième transistor à effet de champ (P1) à canal d'un deuxième type de conductivité différent du premier type de conductivité, ledit deuxième transistor étant monté en diode entre ladite première borne d'alimentation (12) et une deuxième source de courant (22), le noeud de connexion (24) entre ledit deuxième transistor et ladite deuxième source de courant étant connecté à la borne de commande dudit premier transistor.

4. Circuit d'initialisation (20) selon la revendication 3, caractérisé en que ledit seuil d'initialisation ($V_{RST1}$) est défini selon la formule suivante :

$$V_{RST1} = Vth_{N0} + (2I_{DS(N0)}/\beta_{N0})^{1/2} + Vth_{P1} + (2I_{DS(P1)}/\beta_{P1})^{1/2}$$

où les références $Vth_{N0}$ et $Vth_{P1}$ désignent respectivement les tensions de seuil desdits premier et deuxième transistors (N0, P1), les références $I_{DS(N0)}$ et $I_{DS(P1)}$ désignent respectivement les intensités des courants traversant lesdits premier et deuxième transistors, la référence $\beta_{N0}$ désigne le gain du transistor N0, ce gain étant défini par

la formule suivante :

$$\beta_{N0} = k_{N0} * W_{N0}/L_{N0}$$

où la référence $k_{N0}$ désigne la transductance dudit premier transistor, et les références $W_{N0}$ et $L_{N0}$ désignent respectivement les largeur et longueur nominales du canal dudit premier transistor, et la référence $\beta_{P1}$ désigne le gain du transistor P1, ce gain étant défini par la formule suivante :

$$\beta_{P1} = k_{p1} * W_{P1}/L_{P1}$$

où la référence $k_{p1}$ désigne la transductance dudit deuxième transistor, et les références $W_{P1}$ et $L_{P1}$ désignent respectivement les largeur et longueur nominales du canal dudit deuxième transistor.

**5.** Circuit d'initialisation (30) selon la revendication 3, caractérisé en ce qu'il comprend en outre au moins un troisième transistor à effet de champ (P2) à canal dudit deuxième type de conductivité, ce transistor étant monté en diode et connecté en série entre ledit deuxième transistor (P2) et ladite première borne d'alimentation (12).

**6.** Circuit d'initialisation (20) selon la revendication 5, caractérisé en qu'il comprend M deuxièmes transistors (P2) identiques audit deuxième transistor, et en ce que ledit seuil d'initialisation ($V_{RSTM}$) est défini selon la formule suivante :

$$V_{RSTM} = Vth_{N0} + (2I_{DS(N0)}/\beta_{N0})^{1/2} + M*[Vth_{P2} + (2I_{DS(P2)}/\beta_{P2})^{1/2}]$$

où les références $Vth_{N0}$ et $Vth_{P1}$ désignent respectivement les tensions de seuil desdits premier et deuxièmes transistors (N0, P2), les références $I_{DS(N0)}$ et $I_{DS(P1)}$ désignent respectivement les intensités des courants traversant lesdits premier et deuxièmes transistors, la référence $\beta_{N0}$ désigne le gain du transistor N0, ce gain étant défini par la formule suivante :

$$\beta_{N0} = k_{N0} * W_{N0}/L_{N0}$$

où la référence $k_{N0}$ désigne la transductance dudit premier transistor, et les références $W_{N0}$ et $L_{N0}$ désignent respectivement les largeur et longueur nominales du canal dudit premier transistor, et la référence $\beta_{P2}$ désigne le gain du transistor P2, ce gain étant défini par la formule suivante :

$$\beta_{P2} = k_{p2} * W_{P2}/L_{P2}$$

où la référence $k_{p2}$ désigne la transductance desdits deuxièmes transistors, et les références $W_{P2}$ et $L_{P2}$ désignent respectivement les largeur et longueur nominales du canal desdits deuxièmes transistors.

**7.** Circuit d'initialisation (10 ; 20 ; 30) selon l'une des revendications précédentes, caractérisé en qu'il comprend ladite première source de courant (16).

**8.** Circuit d'initialisation (20 ; 30) selon l'une des revendications 3 à 6, caractérisé en qu'il comprend ladite deuxième source de courant (22).

**9.** Circuit d'initialisation (10 ; 20 ; 30) selon l'une des revendications 1 à 6, caractérisé en que ledit circuit intégré (2) comprend ladite première source de courant (16).

**10.** Circuit d'initialisation (20 ; 30) selon l'une des revendications 3 à 6, caractérisé en que ledit circuit intégré (2) comprend ladite deuxième source de courant (22).

**11.** Circuit d'initialisation (10 ; 20 ; 30) selon l'une quelconque des revendications précédentes, caractérisé en ce qu'il comprend en outre un inverseur connecté entre ladite borne de sortie (18) et ledit circuit intégré (2), de sorte que cet inverseur fournit ladite tension d'initialisation (RST0 ; RST1 ; RST2).

**12.** Circuit d'initialisation (10 ; 20 ; 30) selon l'une des revendications 1 à 7, caractérisé en ce qu'il comprend en outre un amplificateur connecté entre ladite borne de sortie (18) et ledit circuit intégré (2), de sorte que cet inverseur fournit ladite tension d'initialisation (RST0 ; RST1 ; RST2).

**13.** Circuit d'initialisation (10 ; 20 ; 30) selon l'une quelconque des revendications précédentes, caractérisé en ce qu'il est réalisé de façon monolithique avec ledit circuit intégré dans un substrat semi-conducteur.

## Fig. 1
(ART ANTERIEUR)

## Fig. 2
(ART ANTERIEUR)

## Fig. 3

## Fig. 4

## Fig. 5

## Fig. 6

Office européen des brevets

**RAPPORT DE RECHERCHE EUROPEENNE**

Numéro de la demande

EP 98 11 6952

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | EP 0 802 632 A (OKI ELECTRIC CO.) 22 octobre 1997 * colonne 7, ligne 43 - colonne 9, ligne 25; figure 1 * | 1-5,7-13 | H03K17/22 |
| Y | * colonne 9, ligne 32 - colonne 10, ligne 14; figures 2-7 * --- | 6 | |
| Y | US 4 873 458 A (T. YOSHIDA) 10 octobre 1989 * colonne 1, ligne 15 - ligne 50; figure 5 * --- | 6 | |
| X | EP 0 831 589 A (SGS-THOMSON) 25 mars 1998 * figures 3,4 * --- | 1-5 | |
| X | US 5 587 866 A (R. YACH ET. AL.) 24 décembre 1996 * colonne 7, ligne 20 - ligne 39; figure 3 * --- | 1 | |
| A | US 4 013 902 A (R. PAYNE) 22 mars 1977 * colonne 3, ligne 10 - colonne 4, ligne 67; figure 1 * ----- | 1-13 | DOMAINES TECHNIQUES RECHERCHES (Int.Cl.6) H03K |

Le présent rapport a été établi pour toutes les revendications

| Lieu de la recherche | Date d'achèvement de la recherche | Examinateur |
|---|---|---|
| LA HAYE | 10 février 1999 | Butler, N |